(19) Europäisches Patentamt
European Patent Office
Office européen des brevets

(11) Veröffentlichungsnummer: **0 307 596**
**A2**

(12) **EUROPÄISCHE PATENTANMELDUNG**

(21) Anmeldenummer: 88112294.9

(22) Anmeldetag: 29.07.88

(51) Int. Cl.⁴: **H01L 21/48 , G03F 7/00**

(30) Priorität: 15.09.87 DE 3731333

(43) Veröffentlichungstag der Anmeldung:
22.03.89 Patentblatt 89/12

(84) Benannte Vertragsstaaten:
BE CH DE ES FR GB IT LI LU NL SE

(71) Anmelder: SCHERING AKTIENGESELLSCHAFT
Berlin und Bergkamen
Müllerstrasse 170/178 Postfach 65 03 11
D-1000 Berlin 65(DE)

(72) Erfinder: Tenbrink, Detlef
Büdnerring 42
D-1000 Berlin 51(DE)

(54) **Verfahren zur Herstellung von Leiternetzwerken.**

(57) Die Erfindung betrifft ein Verfahren zur Herstellung von Leiternetzwerken mit großer Haftfestigkiet, hoher Schicktdicke und Kantenschärfe der Leiterzüge, insbesondere auch zur gleichzeitigen Durchmetallisierung lasergebohrter Keramiksubstrate und beliebiger anderer organischer und anorganischer Dielektrika als Trägermaterialien für elektrische Schaltungen, unter Verwendung metallisierter oder nicht metallisierter Substrate, welche in bereits bekannter Weise vorbehandelt, aktiviert, reduziert und chemisch metallisiert werden, dadurch gekennzeichnet, daß die Platten unmittelbar nach dem Laminieren und Belichten des Fotoresistes, aber vor der Entwicklung des Leiterbildes auf Temperaturen von 40 bis 120° C, vorzugsweise 70 bis 80° C, erwärmt werden.

EP 0 307 596 A2

## VERFAHREN ZUR HERSTELLUNG VON LEITERNETZWERKEN

Die Erfindung betrifft ein Verfahren zur Herstellung von Leiternetzwerken mit großer Haftfestigkeit, hoher Schichtdicke und Kantenschärfe der Leiterzüge, insbesondere auch zur gleichzeitigen Durchmetallisierung lasergebohrter Keramiksubstrate und beliebiger anderer organischer und anorganischer Dielektrika als Trägermaterialien für elektrische Schaltungen, unter Verwendung metallisierter oder nicht metallisierter Substrate, welche in bereits bekannter Weise vorbehandelt, aktiviert, reduziert und chemisch metallisiert werden.

Die zunehmenden Anforderungen der Mikroelektronik verlangen immer feiner werdende Leiterstrukturen auf keramischen Basismaterialien, um hochintegrierte und miniaturisierte Module aufzubauen.

Dabei kommt es insbesondere auf die gute Wärmeleitfähigkeit der Substrate und die hohe elektrische Leitfähigkeit der darauf aufgebrachten Metallstrukturen an, um die in den aktiven Halbleiterbauelementen entstehende Verlustwärme rasch abzuführen und um Signale mit hohen Schaltfrequenzen zu führen, ohne diese durch ungenügende Leitfähigkeit zu verfälschen.

Die in der Dickschichttechnik durch Siebdruck erreichbaren Strukturen liegen bei etwa 4 Linienpaaren pro mm, das heißt, Breite und Abstand der Bahnen betragen 125 µm.

Das Leiterbahnmaterial besteht nicht aus reinen Metallen, sondern aus Einbrennpasten (zumeist Silber-Palladium Partikel), die zudem mit einer Glasfritte durchsetzt sind. Dadurch resultiert gegenüber anderen Technologien ein schlechteres Hochfrequenzverhalten und eine geringere elektrische Leitfähigkeit.

In der Dünnfilmtechnik werden sehr dünne, aber reine Metallschichten aufgesputtert. Die aus einer Haftschicht und einer gut leitfähigen Endschicht (meist Gold) bestehende ganzflächige Metallisierung wird in der Regel durch Fotoätzverfahren strukturiert.

Es besteht aber auch die Möglichkeit, die dünne Metallschicht galvanisch zu verstärken. Bei der anschließenden Strukturierung nach dem Substraktiv-Verfahren kommt jedoch mit zunehmender Schichtdicke der Effekt der Unterätzung an den Leiterbahnflanken zum Tragen.

Günstiger ist deshalb die galvanische Verstärkung nur der Leiterbahnen nach Semiadditiv-Verfahren. Dies erlaubt außerdem Materialeinsparungen und den Ersatz des Goldes durch leitfähigeres Kupfer. Als bondbare Endschicht kann auf die Kupferbahnen zuletzt auch eine dünne Lage Gold galvanisch abgeschieden werden.

Die in der Dünnfilmtechnik übliche feine Strukturauflösung wird vorwiegend durch positiv arbeitende Fotolacke erreicht. Diese sind mit Einschränkungen auch für das Semiadditiv-Verfahren einsetzbar: Bei Substrakten mit durchmetallisierten Bohrungen ist die Lackschleuder-Beschichtung ungeeignet. Die maximal erreichbare Metallschichtdicke ist die Schichtdicke des verwendeten Fotolackes begrenzt auf etwa 5 µm.

Die für den galvanischen Aufbau von mehr als 5 µm Leiterbahndicke notwendigen Trockenresiste lassen je nach Typ und Resistdicke bei üblicher Verarbeitung nur Strukturierungen von etwa 6 bis 7 Linienpaaren pro mm zu (ca. 80 µm bei einer Resistdicke von 40 µm).

Diese Grenze gilt auch für die industrielle Serienfertigung von Leiterplatten auf Basis von glasfaserverstärktem Epoxidharz, Phenolharzpapier, Epoxidharzpapier, Plexiglas, Polysulfon, Polyimid, Polyamid, Polyphenylenoxid-Polystyrol, Fluorkohlenwasserstoffen, Polycarbonat, Polyätherimid, oxidischer und nicht oxidischer Keramik und emaillierten Substraten.

Die Erfindung hat die Aufgabe, ein Verfahren zur Verfügung zu stellen, welches eine höhere Liniendichte des Leiterbildes bei gleichzeitig verbesserter Resisthaftung auf der Substratoberfläche und Kantenschärfe der Strukturen ermöglicht.

Diese Aufgabe wird durch ein Verfahren gemäß dem kennzeichnenden Teil des Patentanspruchs gelöst.

Das erfindungsgemäße Verfahren ermöglicht in bisher nicht erreichter Weise eine höhere Liniendichte des Leiterbildes und außerdem die hierfür notwendige bessere Resisthaftung.

Es läßt sich überraschenderweise für alle Bereiche der Hybrid-und Leiterplattentechnik einsetzen, die Feinstleiter bei gleichzeitig hoher Leiterbahnschichtdicke und hoher Kantenschärfe erfordern.

Dabei kann sowohl nach dem Semiadditiv-Verfahren von beliebigen metallisierten Basismaterialien ausgegangen werden und der Leiterbahnaufbau auf galvanischem Wege erfolgen, als auch nach dem Volladditiv-Verfahren eine selektive chemische Metallabscheidung in den ausentwickelten Resistkanälen direkt auf der aktivierten Isolatoroberfläche bewirkt werden.

die nach dem erfindungsgemäßen Verfahren erreichbare Auflösung in Linienpaaren pro mm hängt natürlich entscheidend von der Schichtdicke des verwendeten Resists und der Schutzfolie ab.

Mit einem etwa 40 µm dicken üblichen Trockenresist erreicht man zum Beispiel die doppelte Anzahl an ausentwickelten Linienpaaren pro mm gegenüber der normalen Arbeitsweise, d.h. Strukturbreiten und -abstände von 35-40 μm statt bisher 70-80 μm.

Gleichzeitig wird die Resisthaftung auf der Substratoberfläche und die Kantenschärfe der erzeugten Strukturen erheblich verbessert.

Somit erfüllt das erfindungsgemäße Verfahren alle Voraussetzungen für die Mikrostrukturierung von stromlos und galvanisch abzuscheidenden Metallisierungen mit hoher Schichtdicke im Dünnfilm-Design.

Die nachfolgenden Beispiele dienen zur Erläuterung der Erfindung.

Beispiel 1

Eine nach bekannten Verfahren auf Keramik aufgedampfte oder gesputterte Metallschicht oder eine direkt chemisch metallisierte Dünnfilmkeramik, die auch durchmetallisierte Bohrungen haben kann, wird mit einem etwa 40 μm dicken Lösemittelentwickelbaren Fotopolymer-Trockenresist laminiert.

Nach Abkühlung auf Raumtemperatur wird der Fotoresist durch eine Glasmaske mit dem passenden Layout mit einer UV-Quelle belichtet, vorzugsweise mit einem in der Dünnfilmtechnik üblichen Maskaligner.

Daran anschließend ist die Reaktionszeit von 10 bis 15 Minuten abzuwarten. Während dieser Reaktionszeit werden die belichteten Substrate senkrecht in geeigneten Gestellen stehend 5-10 Minuten lang in einem Umluftofen auf 70-80° C erwärmt.

Nach der Abkühlung auf Raumtemperatur wird die Schutzfolie entfernt und der unbelichtete Resist in einem handelsüblichen Sprühprozessor mit 1.1.1-Trichlorethan ausentwickelt.

Das freigelegte, zu metallisierende Leiterbild und die Bohrlochwandungen werden wie gewohnt gereinigt und in galvanischen Metallisierungsbädern mit den gewünschten Metallen in den erforderlichen Schichtdicken verstärkt.

Danach wird der Fotoresist mit Dichlormethan in handelsüblichen Strippmaschinen entfernt und die freigelegte dünne Leitschicht durch selektive Ätzung entfernt.

Man erreicht Strukturbreiten und -abstände von 35-40 μm.

Beispiel 2

Ein mit Haftvermittler beschichtetes Basismaterial aus glasfaserverstärktem Epoxidharz wird gebohrt und chemisch und/oder mechanisch vom Bohrmehl befreit.

Der Haftvermittler dieser Platte wird dann in einer Chrom-Schwefelsäure aufgeschlossen und anschließend gespült und entgiftet.

Nachfolgend wird die gesamte Oberfläche einschließlich der Bohrungen in einem edelmetallhaltigen Aktivator behandelt, gespült und in einem Reduktor zu den Edelmetallkeimen reduziert.

Nach dem Spülen und Trocknen der Platte bei mehr 100° C erfolgt die Beschichtung mit einem 18 μm dicken lösungsmittellöslichen, negativ arbeitenden Fotopolymer-Trockenresist.

Nach Abkühlung wird das zu dem Bohrbild passende Leiterbild mittels UV-Licht übertragen. Anschließend wird die Platte 5 Minuten lang auf 80° C erwärmt.

Nach der Abkühlung auf Raumtemperatur wird die Schutzfolie vom Resist entfernt und in 1.1.1-Trichlorethan sprühentwickelt.

Das freigelegte, zu metallisierende Schaltbild und die Bohrlochwandung werden nochmals im Reduktor behandelt und gespült.

Unmittelbar danach erfolgt die außenstromlose Metallabscheidung selektiv im freientwickelten Resistkanal und an den Bohrlochwandungen, selbst in 60° C heißen und hochalkalischen Kupferbädern.

Nach Erreichen der gewünschten Metallschichtdicke wird der Fotoresist mit Dichlormethan gestrippt und die übliche weitere Bearbeitung der Platte durchgeführt, wie zum Beispiel Aufbringen einer Lötstoppmaske und Heißverzinnung.

Man erreicht Strukturbreiten und Abstände von 25 - 30 μm.

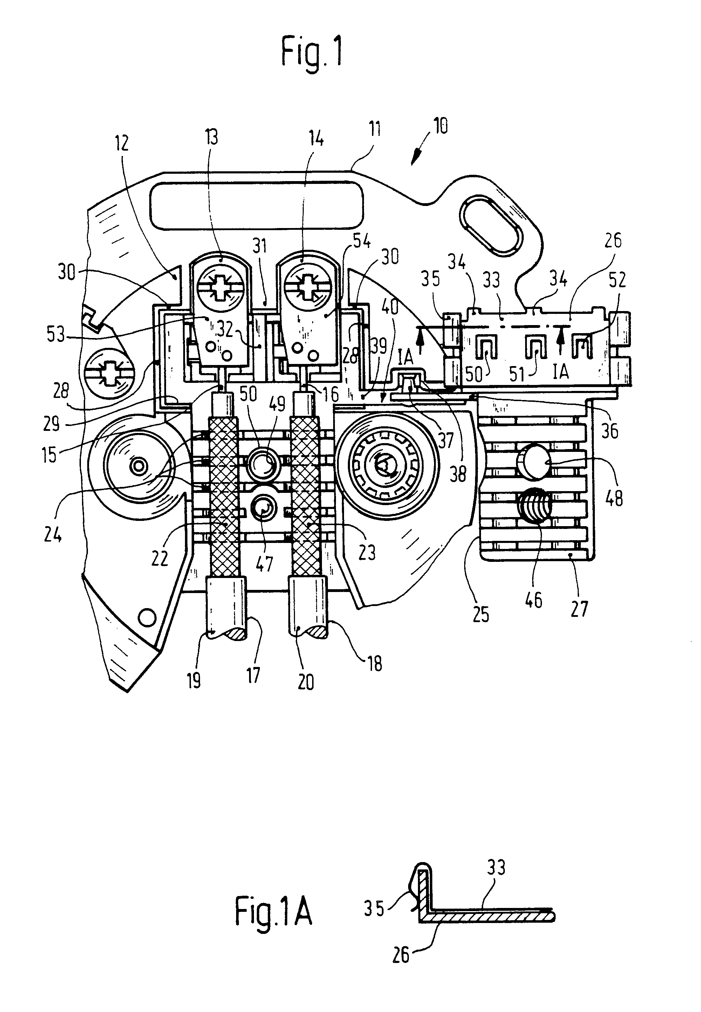

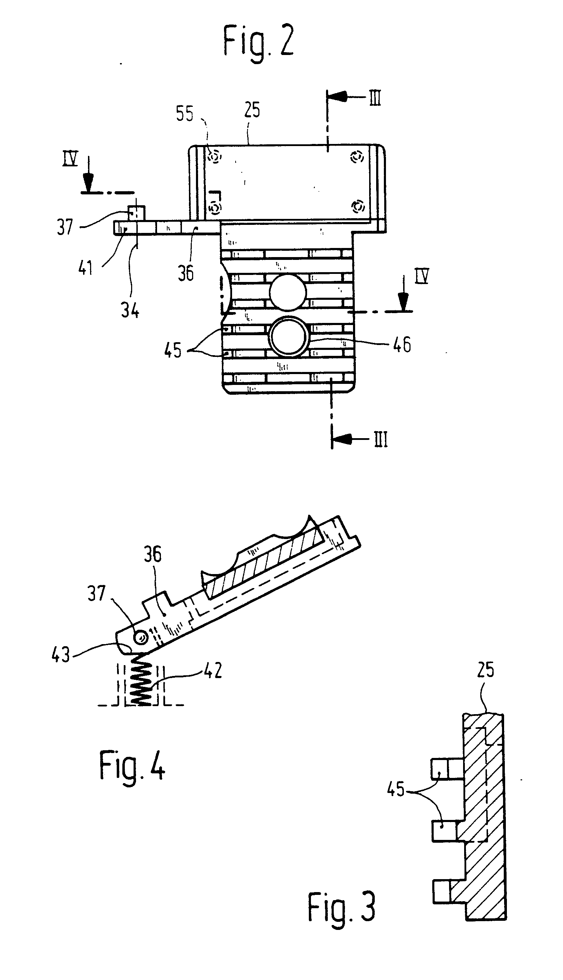

Ansprüche

Verfahren zur Herstellung von Leiternetzwerken mit großer Haftfestigkeit, hoher Schichtdicke und Kantenschärfe der Leiterzüge, insbesondere auch zur gleichzeitigen Durchmetallisierung lasergebohrter Keramiksubstrate und beliebiger anderer organischer und anorganischer Dielektrika als Trägermaterialien für elektrische Schaltungen, unter Verwendung metallisierter oder nicht metallisierter Substrate, welche in bereits bekannter Weise vorbehandelt, aktiviert, reduziert und chemisch metallisiert werden, dadurch gekennzeichnet, daß die Platten unmittelbar nach dem Laminieren und Belichten des Fotoresistes, aber vor der Entwicklung des Leiterbildes auf Temperaturen von 40 bis 120° C, vorzugsweise 70 bis 80° C, erwärmt werden.

24/8/

# Fig. 1

# Fig. 1A

# Fig. 2

# Fig. 4

# Fig. 3